# EUROPEAN PATENT APPLICATION

(11) **EP 1 168 445 A1**
(43) Date of publication of application: **02.01.2002**
(21) Application number: 99961416.7
(22) Date of filing: 27.12.1999
(51) Int. Cl.: H01L 25/04

(54) **INTEGRATED CIRCUIT**

(71) Applicant: MITSUBISHI DENKI KABUSHIKI KAISHA, Tokyo 100-8310 (JP)
(72) Inventor: MORI, Kazuhiro, Mitsubishi Denki, Chiyoda-ku, Tokyo 100-8310 (JP); KOYAMA, Masato, Mitsubishi Denki, Chiyoda-ku, Tokyo 100-8310 (JP)
(74) Representative: Popp, Eugen, Dr.
(86) International application number: JP9907334
(87) International publication number: WO0148821

(57) **Abstract**

An integrated circuit device (1) in accordance with the present invention includes a mother board (2), a module substrate (3), a solder bump (6) and a supporting member (7a). Module substrate (3) is mounted onto mother board (2), and an electronic component (4) is mounted on the front and back surfaces of module substrate (3). Mother board (2) and module substrate (3) are electrically connected through solder bump (6), and supporting member for prohibiting module substrate (3) from inclining is disposed between mother board (2) and module substrate (3).

## Description

### Technical Field

The present invention relates to an integrated circuit device, and more particularly to a connection structure in an integrated circuit device formed by stacking a plurality of substrates with various elements constituting electronic circuits mounted thereon.

### Background Art

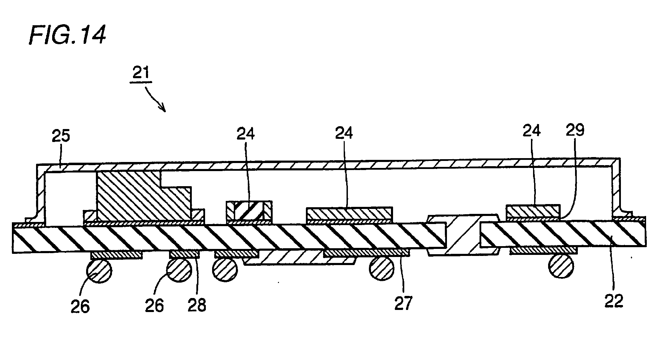

Fig. 14 shows an example of a conventional integrated circuit device. This integrated circuit device is disclosed in Japanese Patent Laying-Open No. 11-67947.

As shown in Fig. 14, an integrated circuit device 21 includes a chip substrate 22, an electronic component 24 mounted on a front surface of chip substrate 22 with a connection layer 29 interposed, a shield case 25, a solder ball 26, an interconnecting pattern 27, and a land 28.

Chip substrate 22 is provided with a through hole, through which connection layer 29 and interconnecting pattern 27 are electrically connected. The chip substrate 22 having the above structure is mounted, for example, onto a mother board (not shown).

When chip substrate 22 is mounted onto the mother board, solder ball 26 is usually fused or melted. However, since a member for supporting chip substrate 22 is not provided, there has been a case where chip substrate 22 may be mounted in an inclined manner. Thus, when the component is mounted on the back surface of chip substrate 22 opposing to the mother board, for example, there has been a problem that the component is pushed onto the mother board and damaged, lowering the reliability of integrated circuit device 21.

### Disclosure of the Invention

The present invention is made to solve the above-mentioned problem. An object of the present invention is to improve the reliability of an integrated circuit device for electrically connecting a plurality of substrates by means of a solder bump.

An integrated circuit device in accordance with the present invention includes a first substrate portion, a second substrate portion, a solder bump, and a supporting member. The second substrate portion is mounted onto. the first substrate portion. The solder bump electrically connects the first substrate portion and the second substrate portion. The supporting member is disposed between the first substrate portion and the second substrate portion, and supports the second substrate portion above the first substrate portion. The substrate portion as used herein covers both a substrate itself and an element constituting an electronic circuit, such as various components and an interconnection provided on the substrate.

By disposing the supporting member between the first substrate portion and the second substrate portion in this manner, the second substrate portion can be supported with the supporting member at the time of mounting the second substrate portion, so that inclination of the second substrate portion can be prevented. In other words, the space between the first substrate portion and the second substrate portion can be maintained uniform. As a result, when the component is mounted on the back surface of the second substrate opposing to the first substrate portion, the component can be prevented from being pushed onto the first substrate portion and thus from being damaged.

The above mentioned supporting member preferably adjusts the space between the first substrate portion and the second substrate portion such that the width of the solder bump is greater than the height of the solder bump.

By providing the solder bump in such an oblong shape, not only the contact area between the solder bump and conductive layers on the surfaces of the first and second substrate portions, but also the connecting strength between the first substrate portion and the second substrate portion can be increased, and in addition, the contact resistance can be reduced.

More preferably, the above mentioned supporting member adjusts the space between the first substrate portion and the second substrate portion such that the height of the solder bump is at least 86 % and at most 93 % of the width of the solder bump.

It is understood that the greater width of the solder bump can increase the contact area between the conductive layers on the surfaces of the first and second substrate portions and the solder bump. Too greater width of the solder bump, however, makes it difficult to attain high integration of the solder bumps. Then, through intensive study, the inventors of the present invention has found that when the ratio of the height of the solder bump to the width of the solder bump is within the above mentioned range, high integration of the solder bumps can be attained while the connecting strength between the first substrate portion and the second substrate is kept high.

It is preferable that the diameter of a solder ball for forming the aforementioned solder bump is greater than the height of the supporting member. Specifically, the diameter of the solder ball is 1.1 to 1.2 times the height of the supporting member. Therefore, after the second substrate portion is mounted, the solder bump can be made to have an oblong shape as desired, thereby attaining the above-mentioned effect.

The supporting member is preferably formed of a material having a melting point higher than that of the solder bump. Accordingly, when the solder bump is fused, fusing of the supporting member can be prevented and it is ensured that the second substrate portion can be supported by the supporting member at the time of mounting the second substrate portion.

The supporting member preferably includes a conductive material and electrically connects the first substrate portion and the second substrate portion. Therefore, by using the supporting member as an electrode (a terminal) similar to the solder bump, the number of electrodes can be increased.

The aforementioned supporting member may be formed of a passive device. Specifically, a component such as a resistor, a capacitor, an inductor or the like may be used as the supporting member. By using a part of the elements in an electronic circuit as the supporting member, necessity of providing a supporting member separately can be eliminated, and therefore the number of components can be reduced. Furthermore, the mounting area of the components in the first and the second substrate portions can be decreased.

An electronic component is mounted on the front surface of the second substrate portion, and a shield case for electromagnetically shielding this electronic component from the outside is disposed in such a manner that it covers the electronic component. A leg portion of this shield case may be lengthened onto the first substrate portion to be used as a supporting member.

By using the leg portion of the shield case as the supporting member in this manner, necessity of providing a supporting member separately can be eliminated, and therefore the number of components can be reduced.

It is preferable that the aforementioned supporting member includes a third substrate portion having a plurality of through holes, through which the first substrate portion and the second substrate portion are electrically connected.

By providing the third substrate portion as the supporting member in this way, the first substrate portion and the second substrate portion can be electrically connected via the plurality of through holes provided in this third substrate portion. Accordingly, the number of the electrodes can be increased.

It is preferable that the electronic component is mounted on the back surface of the second substrate opposing to the first substrate portion, and that a recessed portion is provided in the first substrate portion at a position opposing to the above mentioned electronic component.

Therefore, the space between the first substrate portion and the second substrate portion can be decreased, enabling miniaturization of the integrated circuit device.

### Brief Description of the Drawings

Fig. 1 is a cross sectional view of an integrated circuit device in accordance with a first embodiment of the present invention.
Fig. 2 is a cross sectional view showing an examplary shape of a solder bump in accordance with the present invention.
Fig. 3 is a cross sectional view of an integrated circuit device in accordance with a second embodiment of the present invention.
Fig. 4 is a cross sectional view of a modification of the second embodiment.
Fig. 5 is a cross sectional view of an integrated circuit device in accordance with a third embodiment of the present invention.
Fig. 6 is a cross sectional view of an integrated circuit device in accordance with a fourth embodiment of the present invention.
Fig. 7 is a cross sectional view showing a modification of the fourth embodiment.
Fig. 8 is a cross sectional view of an integrated circuit device in accordance with a fifth embodiment of the present invention.
Fig. 9 is a cross sectional view of an integrated circuit device in accordance with a sixth embodiment of the present invention.
Fig. 10 is a cross sectional view of an integrated circuit device in accordance with a seventh embodiment of the present invention.
Fig. 11 is a planar view of a supporting member in accordance with the seventh embodiment of the present invention.
Fig. 12 is a perspective view of a supporting member, a module substrate with components mounted thereon, and a shield case in accordance with the seventh embodiment of the present invention.
Fig. 13 is a cross sectional view of a modification of the seventh embodiment.
Fig. 14 is a cross sectional view of a conventional integrated circuit device.

### Best Modes for Carrying Out the Invention

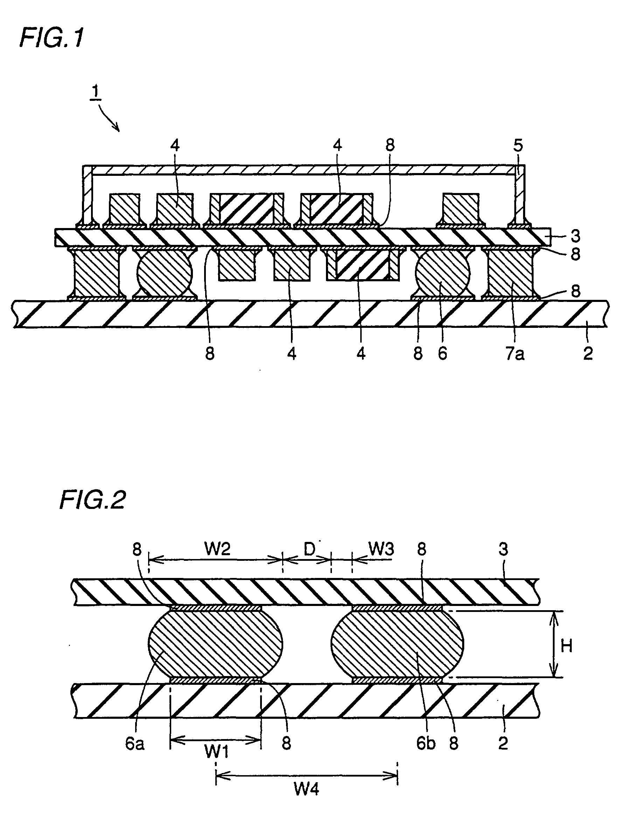

In the following, embodiments of the present invention will be described with reference to Figs. 1 to 13.

### (First Embodiment)

Fig. 1 is a cross sectional view showing an integrated circuit device in accordance with a first embodiment of the present invention. As shown in Fig. 1, integrated circuit device 1 includes a mother board (a first substrate) 2, a module substrate (a second substrate) 3, a solder bump 6, and a supporting member 7a.

Module substrate 3 is supported by supporting member 7a above mother board 2, and on the front and back surfaces of module substrate 3, an element constituting an electronic circuit including a variety of electronic components 4, an integrated circuit or the like is mounted. Electronic component 4 is mounted on a pad 8 made of a conductive material and is fixed to pad 8 by a conductive layer such as a solder layer. A shield case 5 is disposed over module substrate 3 in such a manner that it covers electronic component 4. This shield case 5 has such a function that it electromagnetically shields the electronic circuit portion formed on the front surface of module substrate 3 from the outside, and is formed, for example, of metal or the like.

A plurality of solder bumps 6 are provided, for example in a vertical direction with respect to the page in Fig. 1, to electrically and mechanically connect mother board 2 and module substrate 3, and the bumps have oblong shapes. This solder bump 6 is also bonded to mother board 2 and module substrate 3 through pads 8 and the solder layers.

By providing the solder bump 6 in such an oblong shape as stated above, not only the contact area between pad 8 and solder bump 6, but also the connecting strength between mother board 2 and module substrate 3 can be increased, and in addition, the contact resistance between pad 8 and solder bump 6 can be reduced. Too greater width of solder bump 6, however, makes it difficult to attain high integration of solder bumps 6.

The inventors of the present invention then has studied to keep the reliability of the connecting portion between solder bump 6 and each substrate, to reduce the connecting resistance, and to attain high integration of solder bumps 6. As a result, it is conceived that when the space between mother board 2 and module substrate 3 is at a predetermined value, (in this case about 0.65 mm), the shape and the like of solder bump 6 may be set as follows.

Fig. 2 is an enlarged view of solder bumps 6a and 6b as well as the vicinity thereof. As shown in Fig. 2, a plurality of solder bumps 6a and 6b are preferably formed at a distance D, for example 0.52 mm to 0.57 mm apart. Spacing apart at the aforementioned distance D can prevent solder bumps 6a and 6b from contacting each other after being fused.

Furthermore, the respective widths W2 of solder bumps 6a and 6b are preferably 0.70 mm to 0.75 mm, for example. In this case, the respective heights H of solder bumps 6a and 6b are 0.65 mm. Accordingly, the ratio of heights H to widths W2 of solder bumps 6a and 6b is not less . than 86 % and not more than 93 %. Such a ratio can secure the large contact area between pads 8 and solder bumps 6a and 6b. Therefore, the connecting strength between pads 8 and solder bumps 6a and 6b can be improved, (the reliability of the connecting portion can be improved), and the connecting resistance between pads 8 and solder bumps 6a and 6b can be reduced.

It is noted that the above mentioned height H is set to be higher than the height of electronic component 4 when mounted on the back surface of the module substrate 3 opposing to mother board 2. Furthermore, width W1 of pad 8 is 0.65 mm equal to the aforementioned height H. Still further, center to center width W4 of solder bumps 6a and 6b is 1.27 mm, and the respective protrusion widths W3 of solder bumps 6a and 6b from pads 8 are 0.048mm.

Supporting member 7a is formed of metal in the present embodiment. Accordingly, supporting member 7a can function as an electrode (a terminal) for electrically connecting module substrate 3 and mother board 2, so that the number of electrodes can be increased. This supporting member 7a is also connected to module substrate 3 and mother board 2 through pads 8, and the height of supporting member 7a is equal to the height of solder bump 6.

By disposing the above mentioned supporting member 7a between module substrate 3 and mother board 2, supporting member 7a can support module substrate 3 at the time of mounting module substrate 3, to prevent inclination of module substrate 3. In other words, the space between module substrate 3 and mother board 2 can be maintained uniform.

Therefore, even when the component 4 is mounted on the back surface of module substrate 3 opposing to mother board 2 as shown in Fig. 1, the component 4 can be prevented from being pushed onto mother board 2 and thus from being damaged.

Furthermore, supporting member 7a can also adjust the height of solder bump 6. Accordingly, the shape of solder bump 6 can surely be oblong as shown in Fig. 2, attaining the previously mentioned effect.

Supporting member 7a is formed of a material with a melting point higher than that of solder bump 6. In the present embodiment, for example Ni-plated brass may be used as supporting member 7a. Thus, fusing of supporting member 7a can be prevented when solder bump 6 is fused, and it is ensured that module substrate 3 can be supported by supporting member 7a at the time of mounting module substrate 3.

The diameter of the solder ball for forming the aforementioned solder bumps 6a, 6b is preferably greater than the height of supporting member 7a. Specifically, the diameter of the solder ball is 0.76 mm and 1.17 times the height (0.65 mm) of supporting member 7a. Given this, it is assumed that the diameter of the solder ball may be 1.1 to 1.2 times the height of supporting member 7a.

By making the diameter of the solder ball greater than the height of supporting member 7a in this manner, solder bump 6 can be provided in an oblong shape after module substrate 3 is mounted.

It is noted that, for example, a plurality of metal pieces may be provided so as to support four corners of module substrate 3. Alternatively, a singular metal frame may be provided. This idea is applicable to all the following embodiments.

### (Second Embodiment)

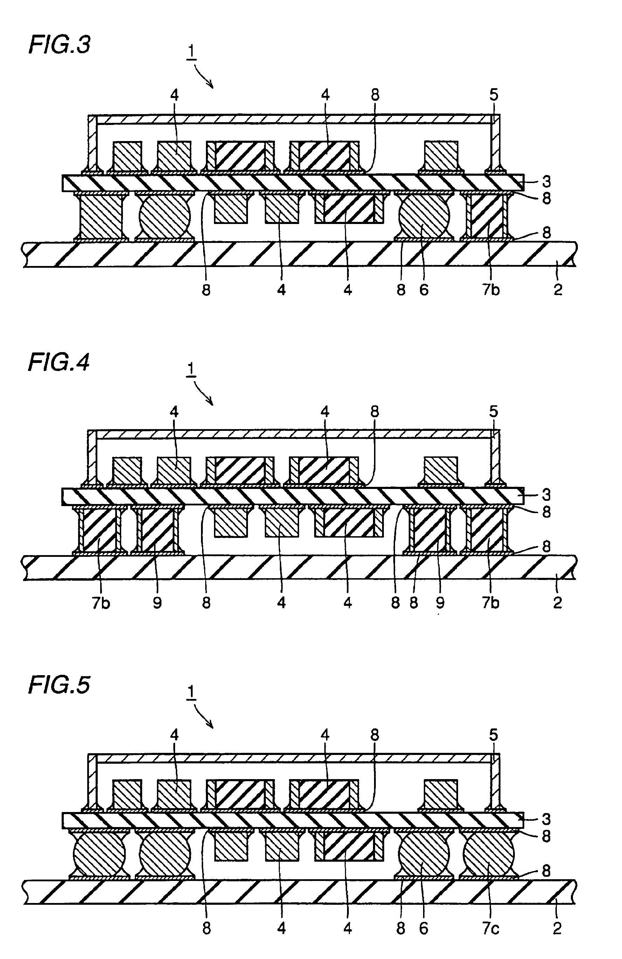

Referring now to Figs. 3 and 4, a second embodiment and a modification thereof in accordance with the present invention will be described. In the second embodiment of the present invention, Ni-plated ceramic is used as the supporting member 7b as shown in Fig. 3. In this case also, the effect similar to the first embodiment can be expected.

It is noted that plating other than Ni, for example solder plating may be applied to ceramic. The supporting member 7b can be used as an electric terminal by such plating. Furthermore, the use of ceramic as supporting member 7b further reduces weight and manufacturing cost as compared with metal pieces.

Referring now to Fig. 4, a modification of the second embodiment in accordance with the present invention will be described. As shown in Fig. 4, a terminal 9 having a structure similar to supporting member 7b may be formed instead of solder bump 6.

### (Third Embodiment)

Referring now to Fig. 5, a third embodiment in accordance with the present invention will be described. In the third embodiment, a metal ball having a melting point higher than that of solder bump 6 is used as the supporting member 7c. In this case also, the effect similar to the first embodiment can be expected.

For example a high-temperature solder ball can be used as supporting member 7c. This high-temperature solder ball is the one in which the ratio of lead (Pb) to zinc (Zn) is changed from that of solder bump 6. Specifically, the high-temperature solder ball can be obtained with a high ratio of lead to zinc.

Furthermore, the use of a metal ball in accordance with the present embodiment can reduce manufacturing cost as compared with metal pieces.

### (Fourth Embodiment)

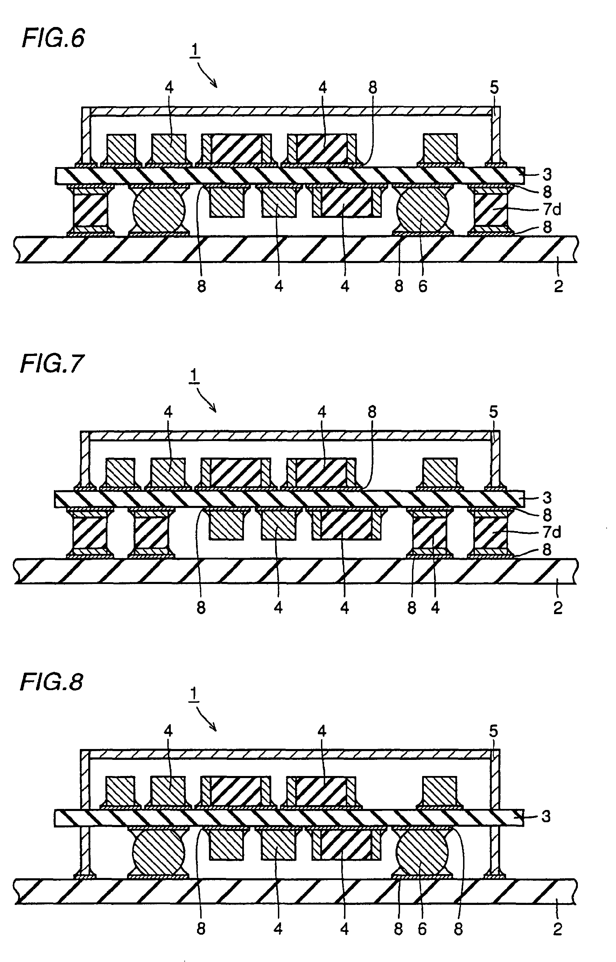

Referring now to Figs. 6 and 7, a fourth embodiment and a modification thereof in accordance with the present invention will be described. In the fourth embodiment, an electronic component is used as the supporting member 7d as shown in Fig. 6. Specifically, a passive device such as a resistor, a capacitor, an inductor or the like may be used as supporting member 7d.

By using a part of elements in an electronic circuit as supporting member 7d in this manner, necessity of providing the supporting member 7d separately can be eliminated and therefore the number of components can be reduced. In addition, the mounting area of the component in module substrate 3 and mother board 2 can be reduced.

As shown in Fig. 6, the passive device is mounted in such a manner that it stands with respect to mother board 2 and module substrate 3. In this case, the passive device is preferably disposed, for example, at four corners of module substrate 3 so as to support module substrate 3 at multiple places.

Referring now to Fig. 7, a modification of the fourth embodiment will be described. As shown in Fig. 7, a component 4 such as a passive device may be used as a terminal instead of solder bump 6.

### (Fifth Embodiment)

Referring now to Fig. 8, a fifth embodiment in accordance with the present invention will be described. In the fifth embodiment, leg portion of shield case 5 is used as the supporting member. More specifically, the leg portion is lengthened onto mother board 2 to serve as the supporting member.

In order to lengthen the leg portion of shield case 5 onto mother board 2, for example, a pierced hole for receiving the leg portion is provided in module substrate 3, and supporting portion for supporting module substrate 3 is provided at the above mentioned leg portion. Accordingly, this supporting portion can support module substrate 3.

By using the leg portion of shield case 5 as the supporting member in this manner, necessity of providing a supporting member separately can be eliminated and therefore the number of components can be reduced. Accordingly, the manufacturing cost can be reduced.

### (Sixth Embodiment)

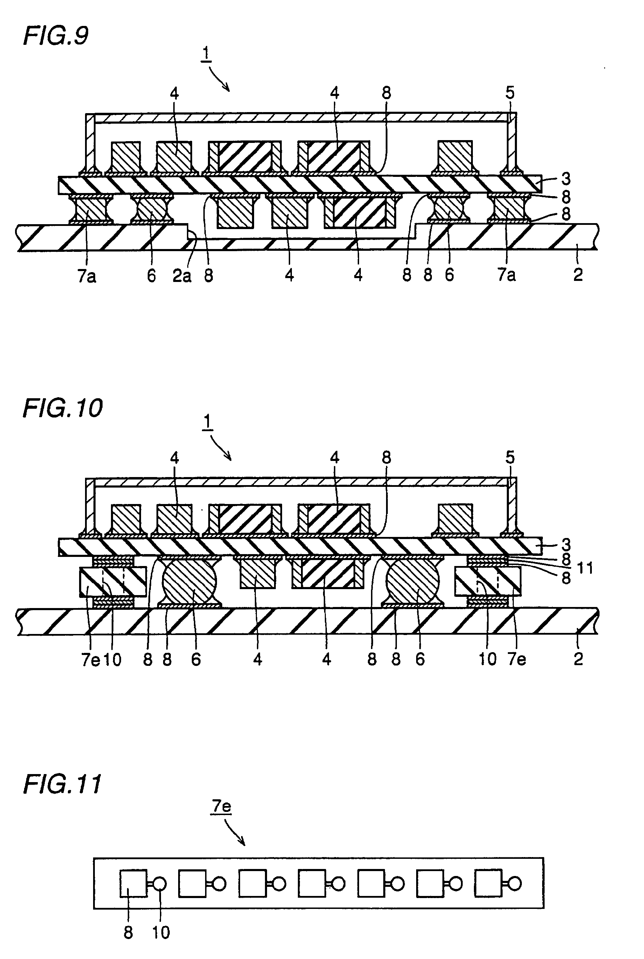

Referring now to Fig. 9, a sixth embodiment in accordance with the present invention will be described. In the sixth embodiment, in mother board 2, a recessed portion 2a is provided at a position opposing to the component 4 mounted on the back surface of module substrate 3, as shown in Fig. 9.

Thus, the space between mother board 2 and module substrate 3 can be reduced, and integrated circuit device 1 can be reduced in a height direction, so that the miniaturization of integrated circuit device 1 becomes possible.

It is noted that a pierced hole may be provided in mother board 2 instead of recessed portion 2a. Furthermore, the idea in accordance with the present embodiment may be applicable to all the other embodiments.

### (Seventh Embodiment)

Referring now to Figs. 10 to 13, a seventh embodiment and a modification thereof in accordance with the present invention will be described. In the seventh embodiment, a substrate is used as the supporting member 7e as shown in Fig. 10.

As shown in Fig. 11, the aforementioned substrate has a plurality of through holes 10, and pads 8 are formed on the front and back surfaces of the substrate. A conductive layer is formed in the through hole to electrically connect the conductive layer and the pads 8. The pads 8 on the front and back surfaces of the substrate are electrically connected to the pad 8 on the front surface of mother board 2 with solder layer 11 interposed and to the pad 8 on the back surface of module substrate 3. Accordingly, mother board 2 and module substrate 3 can be electrically connected via the aforementioned through hole 10.

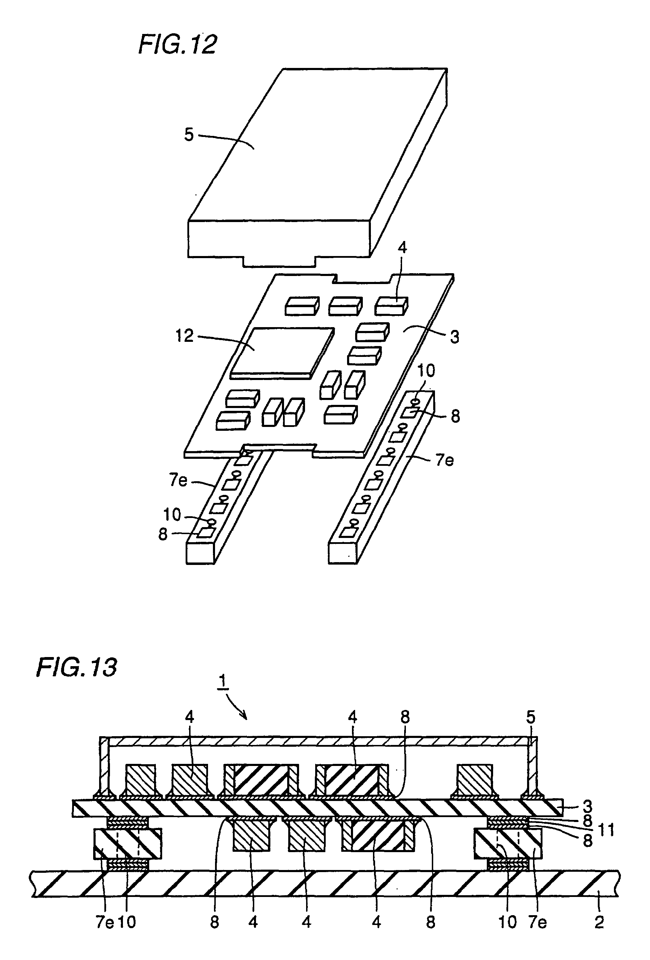

Fig. 12 is a perspective view of shield case 5, module substrate 3 and supporting members 7e. As shown in this figure, an integrated circuit 12 and other electronic components 4 are mounted on the surface of module substrate 3, and a pair of supporting members 7e stretch out in a longitudinal direction. Between these supporting members 7e, solder bumps 6 will be disposed. The supporting members 7e extending long in this manner can effectively prevent solder bump 6 fused at the time of mounting module substrate 3 from flowing out of supporting members 7e. This can also contribute to improve the reliability of integrated circuit device 1.

Furthermore, by providing a plurality of through holes in supporting members 7e, the conductive layers formed in the through holes can be used as electrodes (terminals), so that the number of electrodes can be increased.

Referring now to Fig. 13, a modification of the seventh embodiment will be described. As shown in Fig. 13, solder bump 6 can be omitted.

While the embodiments in accordance with this invention have been described as above, the features of each embodiment may be combined. Furthermore, it is understood that the embodiments disclosed herein are illustrative rather than restrictive in all aspects. The scope of the present invention is shown in the claims and it is intended that all changes equivalent to and within the claims be embraced.

### Industrial Applicability

The present invention may be effectively applied to an integrated circuit device having a plurality of substrates with electronic components and the like mounted thereon.

## Claims

1. An integrated circuit device, comprising:
a first substrate portion (2);
a second substrate portion (3) mounted onto said first substrate portion;
a solder bump (6) electrically connecting said first substrate portion (2) and said second substrate portion (3); and
a supporting member (7a, 7b, 7c, 7d, 7e) disposed between said first substrate portion (2) and said second substrate portion (3) to support said second substrate portion (3) above said first substrate portion (2).

2. The integrated circuit device according to claim 1, wherein said supporting member (7a, 7b, 7c, 7d, 7e) adjusts a space between said first substrate portion (2) and said second substrate portion (3) such that a width of said solder bump (6) is greater than a height of said solder bump (6).

3. The integrated circuit device according to claim 2, wherein said supporting member (7a, 7b, 7c, 7d, 7e) adjusts the space between said first substrate portion (2) and said second substrate portion (3) such that the height of said solder bump (6) is at least 86 % and at most 93 % of the width of said solder bump (6).

4. The integrated circuit device according to claim 1, wherein a diameter of a solder ball for forming said solder bump (6) is greater than height of said supporting member (7a, 7b, 7c, 7d, 7e).

5. The integrated circuit device according to claim 4, wherein the diameter of said solder ball is 1.1 to 1.2 times the height of said supporting member (7a, 7b, 7c, 7d, 7e).

6. The integrated circuit device according to claim 1, wherein said supporting member (7a, 7b, 7c, 7d, 7e) is formed of a material having a melting point higher than that of said solder bump (6).

7. The integrated circuit device according to claim 6, wherein said supporting member (7a, 7b, 7c, 7d, 7e) includes a conductive material and electrically connects said first substrate portion (2) and said second substrate portion (3).

8. The integrated circuit device according to claim 1, wherein said supporting member (7a, 7b, 7c, 7d, 7e) is formed of a passive element.

9. The integrated circuit device according to claim 1, wherein:
an electronic component (4) is mounted on a front surface of said second substrate portion (3);
a shield case (5) for electromagnetically shield said electronic component (4) from an outside is disposed to cover said electronic component (4); and
a leg portion of said shield case (5) is lengthened onto said first substrate portion (2), the leg portion serving as said supporting member.

10. The integrated circuit device according to claim 1, wherein:
said supporting member includes a third substrate portion (7e) having a plurality of through holes (10); and
said first substrate portion (2) and said second substrate portion (3) are electrically connected via said through holes (10).

11. The integrated circuit device according to claim 1, wherein:
an electronic component (4) is mounted on a back surface of said second substrate portion (3) opposing to said first substrate portion (2); and
a recessed portion (2a) is provided in said first substrate portion (2) at a position opposing to said electronic component (4).
